# EUROPEAN PATENT SPECIFICATION

(11) **EP 3 840 135 B1**
(45) Date of publication and mention of the grant of the patent: **13.09.2023**
(21) Application number: 19218849.8
(22) Date of filing: 20.12.2019
(51) Int. Cl.: H01R 13/66, G01R 15/04

(54) **RETROFITTABLE VOLTAGE SENSING DEVICE FOR POWER NETWORKS**
NACHRÜSTBARE SPANNUNGSMESSVORRICHTUNG FÜR STROMNETZE
DISPOSITIF DE DÉTECTION DE TENSION ÉVOLUTIF POUR DES RÉSEAUX D'ALIMENTATION

(43) Date of publication of application: 23.06.2021
(73) Proprietor: 3M Innovative Properties Company, Saint Paul, MN 55133-3427 (US)
(72) Inventor: Gravermann, Mark, 41812 Erkelenz (DE); Schubert, Bernd, 50823 Köln (DE); Stollwerck, Gunther, 47802 Krefeld (DE); Stalder, Michael, 47589 Uedem (DE)
(74) Representative: Müller, Bruno

(56) References cited:
- EP-A1- 2 608 338
- EP-A1- 3 462 183
- WO-A1-2018/211358

## Description

The present disclosure relates to voltage sensing devices for high-voltage and medium-voltage power networks, and especially to those voltage sensing devices that can be retrofitted to existing network equipment.

Power networks transmitting electrical power in large geographic areas, such as national grids, are becoming more complex to operate because nowadays consumers can generate energy on their premises and feed it into these networks in a decentralized manner, at unpredictable times and in unpredictable amounts. Network operators place voltage sensing devices in electrical installations at key locations of their network, such as in switchgears or transformers to collect information about the current state of their power network.

A rather common type of voltage sensing devices for this purpose comprises a voltage divider, i.e. a chain of impedance elements (resistors, capacitors or inductors), electrically serially connected between an element on the elevated voltage to be sensed and electrical ground. Such a voltage divider is described, for example, in the European patent application published as EP 3 223 014 A1. The international patent application published as WO 2018/211358 A1 refers to a sensor for a separable connector which includes a plug body that can be inserted into the separable connector to encase a high-voltage conductor therein. A further European patent application, EP 3 462 183 A1, relates to a voltage sensor in a separable connector of a high-voltage/medium-voltage (HV/MV) power network, the sensor comprising an adapter element and a separate sensor body including a divider assembly with discrete impedance elements. AnotherEuropean patent application, EP 2 608 338 A1, is directed to a terminal connection device for connecting a HV/MV power cable to a connection point, which in one embodiment comprises a voltage sensor.

The infrastructure of certain power networks is not provided with voltage sensing devices yet. It is desirable to provide voltage sensing devices that can be added to existing elements of such networks ("retrofitted") without having to replace existing components. Such retrofittable voltage sensing devices should come at low cost and yet provide adequate and safe electrical insulation of the elevated voltage against ground.

The present disclosure attempts to address these needs. It provides a voltage sensing device for sensing an elevated voltage of a power conductor in a power distribution network of a national grid, comprising
a) a sensored insulation plug comprising
   - a voltage sensor for sensing the elevated voltage, comprising a high-voltage contact for electrical connection to the power conductor;
   - a plug mating portion, shaped to mate the sensored insulation plug with a corresponding socket mating portion of a separable connector, wherein the high-voltage contact is arranged in the plug mating portion such that the high-voltage contact can be connected to the elevated voltage of the separable connector when the sensored insulation plug is mated with the separable connector;
b) a tubular insulating sleeve, comprising a socket mating portion shaped as a socket mating portion of the separable connector and mated with the plug mating portion of the insulation plug;
c) a conductive rod having a first end portion for electrical connection to the power conductor, and an opposed second end portion, electrically connected to the high-voltage contact and arranged in the insulating sleeve.

The plug mating portion of existing insulation plugs, with a sensor ("sensored") or without sensor, and the socket mating portions of existing separable connectors are designed to correspond to, and mate with each other, to form a reliable electrical interface after mating and to insulate the elevated voltage adequately against ground. The voltage sensing devices of the present disclosure comprises such a sensored insulation plug in combination with a conductive rod and an insulating sleeve which has a socket mating portion of an existing separable connector. Using the proven mating interface between a traditional insulation plug and a traditional separable connector is an advantage of the voltage sensing device according to the present invention, because this interface provides a reliable way of connecting a sensored insulation plug with the insulating sleeve and the conductive rod. The sleeve and the rod provide for an insulated "spacer" which keeps the elements of the sensored insulation plug on low voltages or ground away from uninsulated elements on elevated voltage. The corresponding mating portions form a reliable, proven electrical interface after mating. The elements of the voltage sensing devices described herein are available off the shelf at moderate cost, so that the cost of the present retrofittable voltage sensing devices is less than the cost of a custom-made voltage sensing devices.

An insulation plug as referred to herein is an insulation plug as commonly used with separable connectors in medium voltage (MV) or high voltage (HV) power networks. Such insulation plugs are inserted into the rear cavity formed by separable connectors to insulate the connection element in the center of the separable connector after connecting it with a corresponding connection element of, for example, a bushing. Many such insulation plugs have plug bodies of a generally frustro-conical shape. Such plug bodies are typically made of an insulating resin in which a high-voltage electrode and a ground electrode are embedded. An example of an insulation plug is shown and described in the International Patent Application published as WO 2018/211358 A1.

In the context of the present disclosure a sensored insulation plug is an insulation plug comprising a sensor, such as, for example, a sensor embedded (partially or completely) in a plug body of the sensored insulation plug, or a sensor mounted on a surface of the plug body. In particular, a sensored insulation plug may be an insulation plug comprising a voltage sensor for sensing an elevated voltage. A sensored insulation plug may alternatively - or in addition - comprise a partial discharge sensor and/or a sensor for receiving signals of a powerline communication system.

The present disclosure relates to voltage sensing devices for use in medium-voltage or high-voltage power distribution networks in which electrical power is distributed via HV/MV cables, transformers, switchgears, substations etc. with currents of hundreds of amperes and voltages of tens of kilovolts. The term "medium voltage" or "MV" as used herein refers to AC or DC voltages in the range of 1 kV to 72 kV, whereas the term "high voltage" or "HV" refers to AC or DC voltages of more than 72 kV. Medium voltage and high voltage are collectively referred to herein as "elevated voltage".

The voltage sensor comprised in the sensored insulation plug of a voltage sensing device according to the present disclosure may comprise a voltage divider, electrically connected between the power conductor on elevated voltage and electrical ground, for sensing the elevated voltage.

The voltage sensor has a high-voltage contact for electrical connection to the power conductor on elevated voltage. It may further comprise a grounding contact for electrical connection to ground. The high-voltage contact may be, for example, a soldering contact on a printed circuit board (PCB) or an end of a wire or a contact in a connector or a metal contact in a plug body.

Where the voltage sensor comprises a voltage divider for sensing the elevated voltage, the voltage divider may comprise a high-voltage portion comprising one or more discrete impedance elements, electrically serially connected with each other and electrically connected to the high-voltage contact, and a low-voltage portion comprising one or more discrete impedance elements, serially connected between the high-voltage portion and ground. In addition, discrete impedance elements, connected electrically parallel between the high-voltage portion and ground may be present in the low-voltage portion. Also, additional discrete impedance elements, connected electrically parallel between the low-voltage portion and the high-voltage contact may be present in the high-voltage portion.

The voltage divider may further comprise a signal contact, electrically arranged between the high-voltage portion and the low-voltage portion of the voltage divider, for providing a signal voltage indicative of the elevated voltage. Where the high-voltage contact is electrically connected to the power conductor on elevated voltage, and the grounding contact is connected to ground, the voltage at the signal contact changes proportionally to the elevated voltage. The proportionality factor depends on the divider ratio of the voltage divider, i.e. on the overall impedance of the high-voltage portion versus the overall impedance of the entire voltage divider. By suitably choosing the overall impedances of the high-voltage portion and of the low-voltage portion, the divider ratio can be adjusted for the voltage divider to yield a suitable signal voltage at the signal contact. Preferably, the signal voltage is in the range of from about 0.1 Volt to about 100 Volt, more preferably, the signal voltage is in the range of from about 1 Volt to about 10 Volt.

Generally, in the context of the present disclosure, the term "impedance element" refers to a capacitor, a resistor, or an inductor. An impedance element, i.e. a capacitor, a resistor, or an inductor may be a discrete impedance element, i.e. a discrete capacitor, a discrete resistor, or a discrete inductor. As used herein, a discrete impedance element is an individual electrical element that exists independently from other electrical elements, from a printed circuit board ("PCB") or from conductive traces on a PCB. In particular, a discrete impedance element is not formed by conductive traces on an outer surface of a PCB, or in a PCB. A discrete impedance element may be, in particular, a surface mount discrete impedance element, i.e. one that can be mounted on an outer surface of a PCB.

In certain embodiments, in which the voltage sensor comprises a voltage divider for sensing the elevated voltage, each impedance element comprised in the high-voltage portion and/or in the low-voltage portion of the voltage divider is a discrete, surface-mount impedance element. In certain of these embodiments, each impedance element comprised in the high-voltage portion and/or in the low-voltage portion is a discrete, surface-mount capacitor.

Discrete surface-mount capacitors of suitable capacitances in the nanofarad and picofarad range are commercially available at high nominal precision ratings and are therefore useful in voltage dividers usable in sensing devices according to the present disclosure. Also, discrete surface-mount capacitors can be replaced more easily. The voltage drop across each impedance element in a chain of serially connected impedance elements is smaller, if the elevated voltage is divided down by a larger number of impedance elements, as opposed to by fewer impedance elements. The requirements for the voltage withstand of the individual discrete impedance elements of the respective chain can thus be lower. Hence, in certain embodiments of the present disclosure, the voltage divider of the voltage sensor comprises more than ten, in other embodiments more than twenty, discrete impedance elements.

The term "mating" as used herein refers to the act of establishing a mechanical connection between two mating elements, where the mechanical connection is established via engaging, in a plug-socket manner, two mating elements having corresponding matching shapes, where a plug is shaped to mate with a specific type of socket, which in turn is shaped to mate with this specific type of plug. Mating refers thus to mechanically engaging two elements with each other that have corresponding shapes, the shapes being specifically designed to fit with each other and to create a particularly reliable engagement.

A separable connector is a component, known in the industry, mounted at an end of a MV/HV power cable to electrically and mechanically connect, in a separable manner, the end of the power cable to a bushing of a switchgear or of a transformer of a power distribution network, e.g. of a national grid. Many separable connectors are T-shaped or elbow-shaped. A separable connector usually has a rear aperture or cavity facilitating access to a cable lug on elevated voltage inside the separable connector, which rear aperture can receive an insulation plug to insulate the cable lug and fill the space of the rear aperture to reduce the risk of electrical discharges. Certain separable connectors are described in the International Patent Application WO 2018/211358.

Many traditional separable connectors can be provided with a matching insulation plug in order to insulate the rear aperture of the separable connector. Such matching pairs of separable connector and insulation plug are commercially available at moderate cost. In many cases, the mechanical interface between a separable connector and an insulation plug is governed by de-facto standards. Many of such interfaces conform to an existing standard for bushings, some form a Type C interface as described in the German standards DIN EN 50180 for bushings and DIN EN 50181 for plug-in type bushings. According to the present disclosure, the plug mating portion of a sensored insulation plug of the voltage sensing device is shaped for mating with a separable connector, i.e. with a socket mating portion of the separable connector. The body of the sensored insulation plug may, for example, have a frustro-conical shape for being inserted into a corresponding socket mating portion, namely a frustro-conical recess of corresponding shape, at a rear side of the separable connector for mating the sensored insulation plug with the separable connector.

While the plug mating portion of the sensored insulation plug is shaped to be mated with a separable connector, in a voltage sensing device according to the present disclosure it is actually mated with the tubular insulation sleeve of the sensored insulation plug. More specifically, the plug mating portion of the sensored insulation plug is mated with a socket mating portion of the tubular insulating sleeve. In order to facilitate this mating, the tubular insulating sleeve comprises a socket mating portion which is shaped as a (i.e. identical with a ) socket mating portion of the separable connector for which the plug mating portion of the sensored insulation plug is designed. This may allow using industry-standard or de-facto standard elements in the manufacture of the voltage sensing devices disclosed herein and can thereby reduce manufacturing cost of the voltage sensing devices.

The high-voltage contact is arranged in the plug mating portion. More specifically, the high-voltage contact is arranged in the plug mating portion such that the high-voltage contact can be connected to the elevated voltage of the separable connector when the sensored insulation plug is mated with a separable connector on elevated voltage. According to the present disclosure, the high-voltage contact is arranged in the plug mating portion of the sensored insulation plug such that the high-voltage contact is connected to the elevated voltage of the conductive rod when the sensored insulation plug is mated with the insulating sleeve. The high-voltage contact may be or comprise, for example, a conductive metal element, with an internal or external thread or without a thread. Where the sensored insulation plug has a frustro-conical mating portion, the high-voltage contact may be arranged at the tip of the frustro-conical section.

The high-voltage contact is arranged in the plug mating portion such that after mating the high-voltage contact is electrically connected to the conductive rod. Via the conductive rod and its first end portion the high-voltage contact can be electrically connected to the power conductor on elevated voltage. This electrical connection transmits the elevated voltage to the voltage sensor for sensing the elevated voltage.

Further to the high-voltage contact in the plug mating portion, the sensored insulation plug may also comprise a grounding contact for electrical connection of the sensored insulation plug and/or of the voltage sensor to electrical ground. Typical insulation plugs have a conductive outer surface portion which is electrically connected to ground.

The insulating sleeve of a voltage sensing device according to the present disclosure has a generally tubular shape. It is adapted to receive and envelope the second end portion of the conductive rod, or, in certain embodiments, the second end portion and a middle portion, or, in certain embodiments, the first end portion, the second end portion and the middle portion of the conductive rod. In certain embodiments it is adapted to receive and envelope the entire conductive rod.

The insulating sleeve may be made of, or comprise, an elastically expandable material. The insulating sleeve may thus be elastically expandable, either in its length direction (i.e. axially) or orthogonally thereto (i.e. radially), or both axially and radially. An elastically expandable insulating sleeve can be pushed over the conductive rod and, after being pushed on, be in a tight surface contact with the conductive rod.

Alternatively, the insulating sleeve may be made of, or comprise, an elastically shrinkable material. The insulating sleeve may thus be shrinkable, either in its length direction (i.e. axially) or orthogonally thereto (i.e. radially), or both axially and radially. In certain embodiments, before shrinking radially, the sleeve may be held in a radially expanded state by a removable core, for example one comprising spiral windings forming a cylindrical removable core. When the core is removed, the insulating sleeve shrinks radially. Such so-called cold-shrink sleeves are particularly easy to shrink, e.g. about the conductive rod, by removing the core.

In other embodiments the insulating sleeve is a so-called heat shrink sleeve. Such a sleeve shrinks when being externally heated. A heat-shrinkable insulating sleeve may be particularly cost-effective to manufacture.

The tubular insulating sleeve may have a generally cylindrical shape, defining a circular cross section. Other tubular insulating sleeves may have oval or elliptic cross sections.

Generally, the insulating sleeve may be made of, or comprise, an electrically insulating polymeric material. It may, for example, be made of, or comprise, a synthetic rubber material, such as EPDM (ethylene propylene diene monomer rubber) or a silicone rubber or natural rubber.

The tubular shape of the insulating sleeve defines opposed end portions at opposed ends of its tubular shape. The socket mating portion of the tubular insulating sleeve may be arranged at one end portion of the opposed end portions of the insulating sleeve.

Generally, the insulating sleeve comprises a socket mating portion which is mateable, and mated, with the plug mating portion of the sensored insulation plug. The socket mating portion is shaped like a socket mating portion of a separable connector for which the sensored insulation plug is designed and shaped. Due to being designed for each other, the socket mating portion and the plug mating portion can be mated easily and reliably, and hence the insulating sleeve and the sensored insulation plug can be mated easily and reliably.

The socket mating portion may generally form a recess or an open cavity, into which the plug mating portion can be inserted for mating. Generally, the socket mating portion is shaped to complement the shape of the plug mating portion, so that after mating the number and size of voids between the socket mating portion and the plug mating portion are minimal. Where for example the plug mating portion has a generally protruding frustro-conical shape, the socket mating portion may have a generally receding frustro-conical shape.

The conductive rod is a rigid element which facilitates electrical connection of the voltage sensor to the power conductor on elevated voltage.

The length of the conductive rod is chosen suitably to establish a sufficient geometrical distance between the power conductor and a grounding contact of the sensored insulation plug, or between a non-insulated first end portion and the grounding contact of the sensored insulation plug.

In certain embodiments of the voltage sensing device according to the present disclosure the sensored insulation plug comprises an internal thread for engagement of, and electrical connection with, the conductive rod. An internal thread is a common and reliable mechanism for engagement with an element having an external thread. Where the internal thread and the external thread are made from a conductive material, the threads provide for a particularly reliable mechanical and electrical connection.

In certain embodiments of the voltage sensing device described herein the voltage sensor comprises a grounding contact for connection to ground and a signal contact for providing a divided voltage indicative of the elevated voltage, each arranged on the sensored insulation plug such as to be accessible after mating the sensored insulation plug with the insulating sleeve. The grounding contact and the signal contact being accessible after mating facilitates electrical connection of the voltage sensor and can thereby save installation cost.

In certain embodiments the voltage sensor comprises a voltage divider for sensing the elevated voltage of the power conductor, the voltage divider comprising the high-voltage contact, a grounding contact for connection to ground, a signal contact for providing a divided voltage indicative of the elevated voltage, and a plurality of discrete impedance elements, electrically connected in series between the high-voltage contact and the grounding contact, for dividing the elevated voltage and providing, at the signal contact, a signal voltage varying proportionally with the elevated voltage.

A voltage divider is a proven and economical means for sensing elevated voltages with a high degree of accuracy. Building a voltage divider using discrete impedance elements allows use of off-the-shelf electronic components like resistors, capacitors and inductors which are commercially available at low cost and at high accuracy.

In certain embodiments the plurality of discrete impedance elements is adapted such that the proportionality factor between the signal voltage and the elevated voltage is between 1:100 and 1 :50'000 at an elevated voltage of 72 kilovolt and a frequency of 50 Hertz. For a broad range of elevated voltages proportionality factors in this range may result in signal voltages in ranges that can easily be captured, sensed and processed by existing off-the-shelf electronic components. Also, such proportionality factors can be obtained by voltage dividers using common electronic components, e.g. common capacitors, making the voltage sensing device more economical to manufacture.

In certain embodiments of the voltage sensing device as described herein the plug mating portion of the insulation plug is mated with the tubular insulating sleeve releasably. A releasable mating is a mating which permits un-mating of the sensored insulation plug from the tubular insulating sleeve, so that the insulation plug can be removed from the voltage sensing device, e.g. when the sensored insulation plug has failed. Once removed, a new sensored insulation plug can be mated with the insulating sleeve and can be connected to the conductive rod.

Power networks may be provided with sensors for parameters other than voltage, such as detectors for powerline communication signals overlaid over the elevated voltage, or a sensor for partial discharges in a power cable. It may therefore appear desirable that a voltage sensor can be easily replaced with a partial discharge sensor, for example, or with a different type of sensor. Also, if a voltage sensor fails, it is desirable that it can be replaced easily with a replacement voltage sensor of the same type. Hence alternatively, an insulation plug of a different type (e.g. with a different sensor, an improved sensor or without a sensor) can be mated with the insulating sleeve. This makes the voltage sensing device more versatile.

In certain embodiments the tubular insulating sleeve comprises an electrical stress control layer. Such a stress control layer may extend over the full length of insulating sleeve, or at least over the full length of an insulation section of the sleeve. The stress control layer(s) generally provide(s) a smoother distribution of electrical field lines and thereby reduce the risk of electrical discharge or partial discharge in the insulating sleeve. The presence of a suitable stress control layer may also allow to reduce the thickness of an insulation layer, thus saving material cost for insulation material. A stress control layer may be made of, or comprise, for example, conductive or semiconductive rubber material or metallic layers or coatings.

In certain embodiments the socket mating portion comprises a conductive or semiconductive layer on an outer surface of the socket mating portion. In certain of these embodiments the electrical stress control layer is electrically connected to the conductive or semiconductive layer on the outer surface of the socket mating portion. This may help ensure a safer operation of the voltage sensing device and may help reduce the risk of electrical discharges.

The conductive layer on an outer surface of the socket mating portion may be made from, or comprise, a conductive or semiconductive rubber. The conductive layer on an outer surface of the socket mating portion may be electrically connected to electrical ground.

In certain embodiments the socket mating portion comprises, on an inner surface of the socket mating portion, a conductive high-voltage electrode layer in electrical contact with the rod and forming a Faraday cage around an area in which the sensored insulation plug contacts the conductive rod. The Faraday cage may help obtain a more uniform field distribution in the area in which the sensored insulation plug contacts the conductive rod, which in turn may reduce the risk of discharges and provide for a more reliable voltage sensing device.

In certain embodiments of the voltage sensing device disclosed herein the tubular insulating sleeve is radially expandable. It may, for example, be elastically expandable, so that it tends to revert to its unexpanded shape after expansion. A radially expandable insulating sleeve can be more easily pushed over the conductive rod and hold on to the rod, which may help reduce labor cost in assembly of the voltage sensing device.

In certain embodiments the tubular insulating sleeve comprises one or more polymeric rubber materials. Polymeric rubber materials are available in both electrically conductive, semiconductive and insulating varieties, and at moderate cost. Polymeric rubber materials can be processed easily, e.g. extruded or molded. Due to the elasticity of rubber materials they can also adapt to certain shapes, within limits. All this may help reduce manufacturing cost for the tubular sleeve and for the sensing device. In some of these embodiments the tubular insulating sleeve consists of one or more polymeric rubber materials. The absence of other materials may make these sleeves more cost-effective to produce.

In certain embodiments the length of the tubular insulating sleeve is thirty centimeters or more. For a broad range of elevated voltages in medium-voltage or high-voltage power distribution networks, this length provides an adequate distance between an exposed non-insulated first end portion of the conductive rod and the low-voltage end portion of the plug body, which may be on electrical ground. The length of the insulating sleeve should be selected such as to be an acceptable balance between safety and cost: a longer sleeve would reduce the risk of discharges, while being more costly to manufacture and occupying more space, for example in a switchgear. A shorter sleeve may be cheaper to manufacture and occupy less space but may not provide as high protection against discharges.

In certain embodiments of the voltage sensing device according to the present disclosure the conductive rod further comprises a middle portion connecting the first end portion and the second end portion, wherein the middle portion is arranged in, and enveloped by, the insulating sleeve. Enveloping and insulating also the middle portion of the rod may further reduce the risk of electrical discharges between the rod and the grounding contact of the sensored insulation plug or other elements on electrical ground in the vicinity of the voltage sensing device.

The present disclosure also provides a medium-voltage or high-voltage switchgear or medium-voltage or high-voltage transformer for a power distribution network of a national grid comprising a power conductor, such as a busbar, on elevated voltage when in use, and a voltage sensing device as described herein, wherein the first end portion of the conductive rod is electrically connected to the power conductor.

The present disclosure further provides a power distribution network in a national grid comprising a power conductor and a voltage sensing device as described herein, wherein the first end portion of the conductive rod is electrically connected to the power conductor.

The invention will now be described in more detail with reference to the following Figures exemplifying particular embodiments of the invention:
- Fig. 1: Perspective view of a first voltage sensor according to the present disclosure before mating the sensored insulation plug with the insulating sleeve; and
- Fig. 2: Sectional view of the first voltage sensor, after mating the sensored insulation plug with the insulating sleeve.

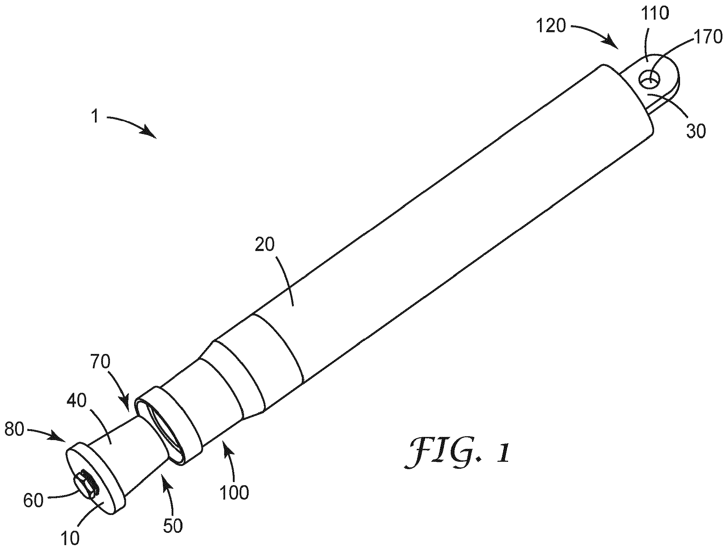

The perspective view of **Figure 1** illustrates a first voltage sensor 1 according to the present disclosure. It is suitable for sensing an elevated voltage of a power conductor in a power distribution network and comprises a sensored insulation plug 10, a tubular insulating sleeve 20 and a conductive rod 30.

The sensored insulation plug 10 is shown separate from the insulating sleeve 20 and the rod 30, i.e. before the insulation plug 10 is mated with the insulating sleeve 20. The insulation plug 10 comprises a plug body 40 of an electrically insulating hardened resin with a voltage sensor embedded in the plug body 40.

In the embodiment shown in Figure 1, the plug body 40 has an elongated shape defining a high-voltage end portion 70, oriented towards the rod 30 on elevated voltage when mated, and a low-voltage end portion 80, oriented generally away from the rod 30 on elevated voltage when mated. At the high-voltage end portion 70, the plug body 40 comprises a plug mating portion 50 which can be received in a corresponding socket mating portion of a separable connector and equally in the corresponding socket mating portion 100 of the insulating sleeve 20. The plug mating portion 50 has a generally frustro-conical shape, adapted for mating the insulation plug 10 with a separable connector or with the insulating sleeve 20.

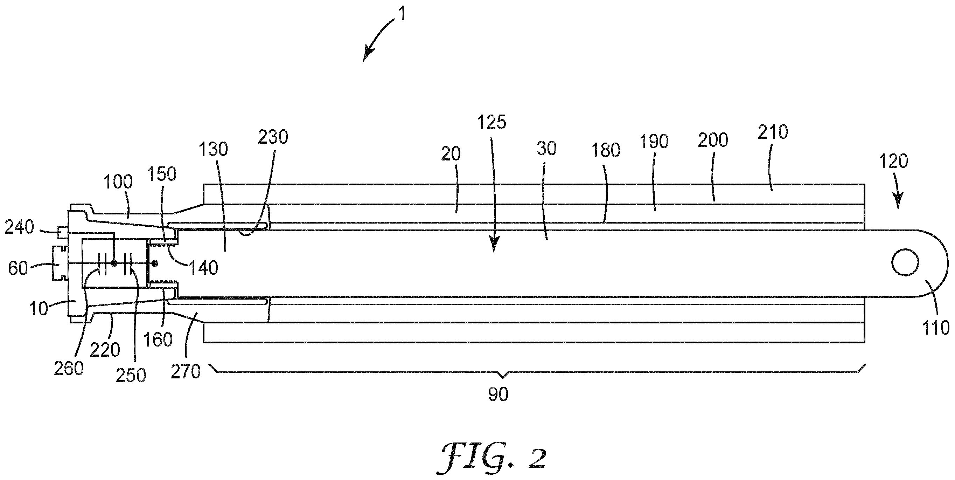

The insulation plug 10 comprises, in the plug mating portion 50, a high-voltage contact (not visible in Figure 1) for connection of the voltage sensor to the elevated voltage of the power conductor. The insulation plug 10 also comprises a grounding contact 60 for connection of the voltage sensor to electrical ground, and a signal contact (not visible in Figure 1, shown in Figure 2) for making the signal voltage, i.e. the output voltage of the voltage sensor, available outside of the plug body 40 for sensing the elevated voltage. Both the grounding contact 60 and the signal contact are arranged at the low-voltage end portion 80 of the plug body 40.

Turning now to the tubular insulating sleeve 20, the function of this sleeve 20 is to electrically insulate the conductive rod 30, which is on elevated voltage when in use, and the high-voltage contact of the insulation plug 10, so as to reduce the risk of electrical discharges between these components and elements on ground in the vicinity of the voltage sensor 1. The sleeve 20 will be explained in more detail below. However, Figure 1 illustrates that the sleeve 20 comprises a socket mating portion 100 which is shaped identical to a socket mating portion of the separable connector for which the shape of the sensored insulation plug 10 was intended and designed to mate with. In particular it is the shape of the aperture of the sleeve 20 which is to receive the plug mating portion 50 of the insulation plug 10. It is thus particularly the inner surface of the socket mating portion 100 of the sleeve 20 which is shaped suitably to be mated with an insulation plug, and with the sensored insulation plug 10, while the outer surface of the socket mating portion 100 is, at least in the embodiment shown in Figure 1, not critical for mating with the insulation plug 10.

In the embodiment shown in Figures 1 and 2 the tubular sleeve 20 has a length of about 40 centimetres (cm), which provides that non-insulated components on elevated voltage, e.g. the cable lug 110 at the opposed end of the rod 30, are sufficiently far removed from the low-voltage end portion 80 of the plug body 40 and the grounding contact 60 arranged therein.

The insulating sleeve 20 envelopes a major portion of the conductive rod 30. The rod 30 is a metallic rod 30 of elongated shape, of which only the first end portion 120 forming the cable lug 110 is visible in Figure 1, while a middle portion 125 and a second end portion 130 (the end portion 130 which is in the vicinity of the sensored insulation plug 10 when mated) are arranged and enveloped in the sleeve 20 and hence not visible in Figure 1. As will be explained in the context of Figure 2, at its second end portion 130 the rod 30 comprises an external thread 140 which can engage with an internal thread 150 in a conductive metal inlay 160 in the high-voltage end portion 70 of the sensored insulation plug 10. The metal inlay 160 establishes the electrical connection of the voltage sensor of the sensored insulation plug 10, via the rod 30 and its cable lug 110, with the elevated voltage of the power conductor to which the conductive rod 30 is connected when in use. The metal inlay 160 is the high-voltage contact 160 of the voltage sensor.

The insulating sleeve 20 is made of rubber. To envelope the rod 30, the rubber material can be molded around the rod 30, or at least around a portion of the rod 30. Alternatively, a rubber sleeve 20 forming a cavity or a through hole can be manufactured separately, and the rod 30 is pushed into the cavity or the through hole. In either case the rod 30 is held in its position in the insulating sleeve 20 at least by friction between the outer surface of the rod 30 and the inner surface of the sleeve 20.

The first end portion 120 of the rod 30 is not enveloped by the insulating sleeve 20 but protrudes from the sleeve 20. This, in conjunction with a mounting hole 170 in the first end portion 120, facilitates electrical and mechanical connection of this first end portion 120 to the power conductor, such as, for example to a busbar of a switchgear or of a transformer.

**Figure 2** is a sectional view of the first voltage sensor 1 of Figure 1, with the sensored insulation plug 10 mated with the tubular insulating sleeve 20 and electrically connected with the conductive rod 30. The insulating sleeve 20 comprises the socket mating portion 100 and an insulation section 90.

Looking first at the sensored insulation plug 10, the sectional view illustrates the grounding contact 60 and the signal contact 240. Elements of the voltage sensor in the sensored insulation plug 10 are illustrated as elements of a circuit diagram, namely a high-voltage capacitor 250, electrically connected to the rod 30 on elevated voltage via the metal inlay 160, and a low-voltage capacitor 260, electrically connected to the grounding contact 60. The high-voltage capacitor 250 and the low-voltage capacitor 260 form a capacitive voltage divider, connected between the elevated voltage and ground, for sensing the elevated voltage. The signal contact 240 is electrically connected between the high-voltage capacitor 250 and the low-voltage capacitor 260, so that it picks up a divided voltage. This divided voltage is the signal voltage which varies proportionally with the elevated voltage, the proportionality factor being the dividing ratio of the voltage divider which can be calculated from the ratio of the impedance of the high-voltage capacitor 250 to the combined overall impedance of the voltage divider.

The dividing ratio is generally chosen such that the signal voltage is a few Volt, but mostly below 50 Volt, so that commercially available electronic circuitry can measure and process the signal voltage, and thereby determine the elevated voltage of the power conductor.

It should be noted that instead of a single high-voltage capacitor 250, a plurality of serially-connected high-voltage capacitors 250 can be used to form a high-voltage portion of the voltage divider. Similarly, instead of a single low-voltage capacitor 260, a plurality of serially-connected low-voltage capacitors 260 can be used to form a low-voltage portion of the voltage divider.

It should also be noted that instead of capacitors 250, 260, other impedance elements can be used to form the voltage divider. Other impedance elements may, for example, be resistors or inductors. In certain embodiments, the low-voltage portion of the voltage divider (i.e. the portion electrically arranged between the signal contact and electrical ground) comprises one or more discrete resistors, and the high-voltage portion of the voltage divider (i.e. the portion electrically arranged between the signal contact and elevated voltage) comprises one or more discrete resistors.

The high-voltage capacitor 250 and the low-voltage capacitor 260 can be formed in various different ways, and independently from each other. The high-voltage capacitor 260, for example, may be formed by a plate-like electrode that is arranged opposite to the metal inlay 160, so that the plate-like electrode and the metal inlay 160 form the electrodes of the high-voltage capacitor 250, and a portion of the plug body 40 forms the dielectric between the electrodes. Alternatively, the high-voltage capacitor 250 may be a single discrete capacitor 250, as is shown in Figure 2

The low-voltage capacitor 260 may be, for example, a discrete capacitor 260, mounted on a PCB, and arranged in a cavity formed in the plug body 40. Its connection to the grounding contact 60 may be achieved by, for example, a wire or a piece of metal.

The sensored insulation plug 10 is shown mated with the insulating sleeve 20, with the plug mating portion 50 inserted into the socket mating portion 100 of the sleeve 20.

The socket mating portion 100 of the sleeve 20 comprises an insulating body portion 270 which is provided with an electrically conductive outer surface layer 220 which is held on ground to provide a certain amount of shielding for the voltage sensor. On an inner surface of the socket mating portion 100, a conductive high-voltage electrode layer 230 is arranged which is in contact with the rod 30 on elevated voltage. The high-voltage electrode layer 230 is made of a conductive rubber material. It forms a Faraday cage around the area in which the sensored insulation plug 10 contacts the conductive rod 30 to prevent partial discharges in this area.

The insulation section 90 of the insulating sleeve 20 comprises four layers, arranged on top of each other: The innermost layer is an inner stress control layer 180, which is in surface contact with the conductive rod 30. It comprises a high-permittivity material such as carbon-filled silicone rubber, its permittivity εᵣ is between about 15 and about 40. The inner stress control layer 180 is an optional layer, and may be omitted if, for example, the high-voltage electrode layer 230 in the socket mating portion 100 is shaped to form a stress control funnel.

The next layer is an inner insulating layer 190 comprising a non-conductive polymeric rubber material, thick enough to provide reliable electrical insulation of the elevated voltage of the rod 30 against ground. The third layer is an outer stress control layer 200 of about 3 millimeter thickness, made of a material (such as a carbon particle loaded silicone) of high electrical permittivity εᵣ, such as having an εᵣ of >10, to further reduce the risk of excessive concentration of electrical field lines and of related electrical discharges. The outermost layer 210 is an outer insulation layer 210, again of a non-conductive rubber material.

The outer stress control layer 200 and the outer insulation layer 210 help prevent partial discharges at the end of the conductive outer surface layer 220 of the insulating sleeve 20. For that purpose, the outer stress control layer 200 is in electrical contact with the conductive outer surface layer 220 of the sleeve 20.

Optionally, the outer stress control layer 200 and the outer insulation layer 210 can be manufactured as a single co-extruded two-layer tube, that may be pushed over the insulation section 90 and a part of the socket mating portion 100 to form the insulating sleeve 20 as shown in Figures 1 and 2.

For mating, the plug mating portion 50 of the sensored insulation plug 10 is inserted into the socket mating portion 100. By turning the sensored insulation plug 10, the internal thread 150 in the conductive metal inlay 160 in the high-voltage end portion 70 of the sensored insulation plug 10 engages the external thread 140 of the rod 30. This establishes a reliable electrical and mechanical connection between the sensored insulation plug 10, the rod 30 and the insulating sleeve 20.

## Claims

1. Voltage sensing device (1) for sensing an elevated voltage of a power conductor in a power distribution network of a national grid, comprising
a) a sensored insulation plug (10) comprising
- a voltage sensor for sensing the elevated voltage, comprising a high-voltage contact (160) for electrical connection to the power conductor;
- a plug mating portion (50), shaped to mate the sensored insulation plug (10) with a corresponding socket mating portion of a separable connector, wherein the high-voltage contact (160) is arranged in the plug mating portion (50) such that the high-voltage contact can be connected to the elevated voltage of the separable connector when the sensored insulation plug (10) is mated with the separable connector;
**characterized in that** the voltage sensing (1) device further comprises
b) a tubular insulating sleeve (20), comprising a socket mating portion (100) shaped as a socket mating portion of the separable connector
and mated with the plug mating portion (50) of the insulation plug (10);
c) a conductive rod (30) having a first end portion (120) for electrical connection to the power conductor, and an opposed second end portion (130), electrically connected to the high-voltage contact (160) and arranged in the insulating sleeve (20).

2. Voltage sensing device according to claim 1, wherein the sensored insulation plug (10) comprises an internal thread (150) for engagement and electrical connection with the conductive rod (30).

3. Voltage sensing device according to any one of the preceding claims, wherein the voltage sensor comprises a grounding contact (60) for connection to ground and a signal contact (240) for providing a divided voltage indicative of the elevated voltage, each arranged on the sensored insulation plug (10) such as to be accessible after mating the sensored insulation plug (10) with the insulating sleeve (20).

4. Voltage sensing device according to any one of the preceding claims, wherein the voltage sensor comprises a voltage divider for sensing the elevated voltage of the power conductor, the voltage divider comprising the high-voltage contact (160), a grounding contact (60), a signal contact (240) for providing a divided voltage indicative of the elevated voltage, and a plurality of discrete impedance elements (250, 260), electrically connected in series between the high-voltage contact and the grounding contact, for dividing the elevated voltage and providing, at the signal contact (240), a signal voltage varying proportionally with the elevated voltage.

5. Voltage sensing device according to claim 4, wherein the plurality of discrete impedance elements (250, 260) is adapted such that the proportionality factor between the signal voltage and the elevated voltage is between 1:100 and 1:50'000 at an elevated voltage of 72 kilovolt and a frequency of 50 Hertz.

6. Voltage sensing device according to any one of the preceding claims, wherein the plug mating portion (50) of the insulation plug (10) is mated with the tubular insulating sleeve (20) releasably.

7. Voltage sensing device according to any one of the preceding claims, wherein the tubular insulating sleeve (20) comprises an electrical stress control layer (180, 200).

8. Voltage sensing device according to claim 7, wherein the socket mating portion (100) comprises a conductive or semiconductive layer (220) on an outer surface of the socket mating portion (100), and wherein the electrical stress control layer (180, 200) is electrically connected to the conductive or semiconductive layer (220) on the outer surface of the socket mating portion.

9. Voltage sensing device according to any one of the preceding claims , wherein the socket mating portion (100) comprises, on an inner surface of the socket mating portion (100), a conductive high-voltage electrode layer (230) in electrical contact with the rod (30) and forming a Faraday cage around an area in which the sensored insulation plug (10) contacts the conductive rod (30).

10. Voltage sensing device according to any one of the preceding claims, wherein the tubular insulating sleeve (20) is radially expandable.

11. Voltage sensing device according to any one of the preceding claims, wherein the tubular insulating sleeve (20) comprises one or more polymeric rubber materials.

12. Voltage sensing device according to any one of the preceding claims, wherein the length of the tubular insulating sleeve (20) is thirty centimeters or more.

13. Voltage sensing device according to any one of the preceding claims, wherein the conductive rod (30) further comprises a middle portion (125) connecting the first end portion (120) and the second end portion (130), and wherein the middle portion is arranged in, and enveloped by, the insulating sleeve (20).

14. Medium-voltage or high-voltage switchgear or medium-voltage or high-voltage transformer for a power distribution network of a national grid comprising a power conductor, such as a busbar, on elevated voltage when in use, and a voltage sensing device according to any one of claims 1-13, wherein the first end portion (120) of the conductive rod (30) is electrically connected to the power conductor.

15. Power distribution network in a national grid comprising a power conductor and a voltage sensing device according to any one of claims 1-13, wherein the first end portion (120) of the conductive rod (30) is electrically connected to the power conductor.

## Patentansprüche

1. Spannungserfassungsvorrichtung (1) zum Erfassen einer erhöhten Spannung eines Stromleiters in einem Stromverteilernetz eines Verbundnetzes, aufweisend
a) einen sensor-ausgestatteten Isolierstecker (10), aufweisend
- einen Spannungssensor zum Erfassen der erhöhten Spannung, aufweisend einen Hochspannungskontakt (160) für einen elektrischen Anschluss an den Stromleiter;
- einen Steckerverbindungsabschnitt (50), der geformt ist, um den sensor-ausgestatteten Isolierstecker (10) mit einem entsprechenden Buchsenverbindungsabschnitt eines trennbaren Anschlusssteckers zu verbinden, wobei der Hochspannungskontakt (160) in dem Steckerverbindungsabschnitt (50) derart angeordnet ist, dass der Hochspannungskontakt an die erhöhte Spannung des trennbaren Anschlusssteckers angeschlossen werden kann, wenn der sensor-ausgestattete Isolierstecker (10) mit dem trennbaren Anschlussstecker verbunden wird;
**dadurch gekennzeichnet, dass** die spannungserfassende (1) Vorrichtung ferner aufweist
b) eine rohrförmige Isolierhülse (20), aufweisend einen Buchsenverbindungsabschnitt (100), der als ein Buchsenverbindungsabschnitt des trennbaren Anschlusssteckers geformt ist
und mit dem Steckerverbindungsabschnitt (50) des Isoliersteckers (10) verbunden ist;
c) einen leitfähigen Stab (30), der einen ersten Endabschnitt (120) für den elektrischen Anschluss mit dem Stromleiter und einen gegenüberliegenden zweiten Endabschnitt (130) aufweist, der mit dem Hochspannungskontakt (160) elektrisch verbunden und in der Isolierhülse (20) angeordnet ist.

2. Spannungserfassungsvorrichtung nach Anspruch 1, wobei der sensor-ausgestattete Isolierstecker (10) ein Innengewinde (150) für einen Eingriff mit und den elektrischen Anschluss an dem/den leitfähigen Stab (30) aufweist.

3. Spannungserfassungsvorrichtung nach einem der vorstehenden Ansprüche, wobei der Spannungssensor einen Erdungskontakt (60) für einen Anschluss an Erdung und einen Signalkontakt (240) zum Bereitstellen einer geteilten Spannung aufweist, die erhöhte Spannung angibt, die jeweils auf dem sensor-ausgestatteten Isolierstecker (10) derart angeordnet sind, dass sie nach dem Verbinden des sensor-ausgestatteten Isoliersteckers (10) mit der Isolierhülse (20) zugänglich sind.

4. Spannungserfassungsvorrichtung nach einem der vorstehenden Ansprüche, wobei der Spannungssensor einen Spannungsteiler zum Erfassen der erhöhten Spannung des Stromleiters aufweist, der Spannungsteiler aufweisend den Hochspannungskontakt (160), einen Erdungskontakt (60), einen Signalkontakt (240) zum Bereitstellen einer geteilten Spannung, die erhöhte Spannung angibt, und eine Mehrzahl von diskreten Impedanzelementen (250, 260), die in Reihe zwischen dem Hochspannungskontakt und dem Erdungskontakt elektrisch angeschlossen sind, zum Teilen der erhöhten Spannung und Bereitstellen, an dem Signalkontakt (240), einer Signalspannung, die mit der erhöhten Spannung proportional variiert.

5. Spannungserfassungsvorrichtung nach Anspruch 4, wobei die Mehrzahl von diskreten Impedanzelementen (250, 260) derart angepasst ist, dass der Proportionalitätsfaktor zwischen der Signalspannung und der erhöhten Spannung zwischen 1:100 und 1 :50.000 bei einer erhöhten Spannung von 72 Kilovolt und einer Frequenz von 50 Hertz liegt.

6. Spannungserfassungsvorrichtung nach einem der vorstehenden Ansprüche, wobei der Steckerverbindungsabschnitt (50) des Isoliersteckers (10) mit der rohrförmigen Isolierhülse (20) lösbar verbunden ist.

7. Spannungserfassungsvorrichtung nach einem der vorstehenden Ansprüche, wobei die rohrförmige Isolierhülse (20) eine Isolationsbeanspruchungskontrollschicht (180, 200) aufweist.

8. Spannungserfassungsvorrichtung nach Anspruch 7, wobei der Buchsenverbindungsabschnitt (100) eine leitfähige oder halbleitende Schicht (220) auf einer Außenoberfläche des Buchsenverbindungsabschnitts (100) aufweist, und wobei die Isolationsbeanspruchungskontrollschicht (180, 200) an die leitfähige oder halbleitende Schicht (220) auf der Außenoberfläche des Buchsenverbindungsabschnitts elektrisch angeschlossen ist.

9. Spannungserfassungsvorrichtung nach einem der vorstehenden Ansprüche, wobei der Buchsenverbindungsabschnitt (100) auf einer Innenoberfläche des Buchsenverbindungsabschnitts (100) eine leitfähige Hochspannungselektrodenschicht (230) in elektrischem Kontakt mit dem Stab (30) aufweist und einen faradayschen Käfig um einen Bereich ausbildet, in dem der sensor-ausgestattete Isolierstecker (10) den leitfähigen Stab (30) kontaktiert.

10. Spannungserfassungsvorrichtung nach einem der vorstehenden Ansprüche, wobei die rohrförmige Isolierhülse (20) radial expandierbar ist.

11. Spannungserfassungsvorrichtung nach einem der vorstehenden Ansprüche, wobei die rohrförmige Isolierhülse (20) ein oder mehrere polymere Kautschukmaterialien aufweist.

12. Spannungserfassungsvorrichtung nach einem der vorstehenden Ansprüche, wobei die Länge der rohrförmigen Isolierhülse (20) dreißig Zentimeter oder mehr beträgt.

13. Spannungserfassungsvorrichtung nach einem der vorstehenden Ansprüche, wobei der leitfähige Stab (30) ferner einen Mittelabschnitt (125) aufweist, der den ersten Endabschnitt (120) und den zweiten Endabschnitt (130) anschließt, und wobei der Mittelabschnitt in der Isolierhülse (20) angeordnet und von dieser umschlossen ist.

14. Mittelspannungs- oder Hochspannungsschaltanlage oder Mittelspannungs- oder Hochspannungstransformator für ein Stromverteilernetz eines Verbundnetzes, aufweisend einen Stromleiter, wie eine Stromschiene, auf erhöhter Spannung, wenn in Verwendung, und eine Spannungserfassungsvorrichtung nach einem der Ansprüche 1 bis 13, wobei der erste Endabschnitt (120) des leitfähigen Stabs (30) an den Stromleiter elektrisch angeschlossen ist.

15. Stromverteilernetz in einem Verbundnetz, aufweisend einen Stromleiter und eine Spannungserfassungsvorrichtung nach einem der Ansprüche 1 bis 13, wobei der erste Endabschnitt (120) des leitfähigen Stabs (30) an den Stromleiter elektrisch angeschlossen ist.

## Revendications

1. Dispositif de détection de tension (1) servant à détecter une tension élevée d'un conducteur d'énergie dans un réseau de distribution d'énergie d'un réseau national, comprenant
a) une fiche d'isolation à capteur (10) comprenant
- un capteur de tension servant à détecter la tension élevée, comprenant un contact haute tension (160) pour une connexion électrique au conducteur d'énergie ;
- une partie d'accouplement de fiche (50), formée pour accoupler la fiche d'isolation à capteur (10) avec une partie d'accouplement de prise correspondante d'un connecteur séparable, dans laquelle le contact haute tension (160) est disposé dans la partie d'accouplement de fiche (50) de telle sorte que le contact haute tension peut être connecté à la tension élevée du connecteur séparable lorsque la fiche d'isolation à capteur (10) est accouplée au connecteur séparable ;
**caractérisé en ce que** le dispositif de détection de tension (1) comprend en outre
b) un manchon isolant tubulaire (20), comprenant une partie d'accouplement de prise (100) ayant la forme d'une partie d'accouplement de prise du connecteur séparable
et accouplée à la partie d'accouplement de fiche (50) de la fiche d'isolation (10) ;
c) une tige conductrice (30) ayant une première partie d'extrémité (120) pour une connexion électrique au conducteur d'énergie, et une seconde partie d'extrémité opposée (130), électriquement connectée au contact haute tension (160) et disposée dans le manchon isolant (20).

2. Dispositif de détection de tension selon la revendication 1, dans lequel la fiche d'isolation à capteur (10) comprend un filetage interne (150) pour une mise en prise et une connexion électrique avec la tige conductrice (30).

3. Dispositif de détection de tension selon l'une quelconque des revendications précédentes, dans lequel le capteur de tension comprend un contact de mise à la terre (60) pour la connexion à la terre et un contact de signal (240) pour fournir une tension divisée indiquant la tension élevée, chacun étant disposé sur la fiche d'isolation à capteur (10) de manière à être accessible après accouplement de la fiche d'isolation à capteur (10) avec le manchon isolant (20).

4. Dispositif de détection de tension selon l'une quelconque des revendications précédentes, dans lequel le capteur de tension comprend un diviseur de tension servant à détecter la tension élevée du conducteur d'énergie, le diviseur de tension comprenant le contact haute tension (160), un contact de mise à la terre (60), un contact de signal (240) servant à fournir une tension divisée indiquant la tension élevée, et une pluralité d'éléments d'impédance distincts (250, 260), électriquement connectés en série entre le contact haute tension et le contact de mise à la terre, pour diviser la tension élevée et fournir, au niveau du contact de signal (240), une tension de signal variant proportionnellement à la tension élevée.

5. Dispositif de détection de tension selon la revendication 4, dans lequel la pluralité d'éléments d'impédance distincts (250, 260) est conçue de telle sorte que le facteur de proportionnalité entre la tension de signal et la tension élevée est compris entre 1:100 et 1 :50'000 à une tension élevée de 72 kilovolts et une fréquence de 50 Hertz.

6. Dispositif de détection de tension selon l'une quelconque des revendications précédentes, dans lequel la partie d'accouplement de fiche (50) de la fiche d'isolation (10) est accouplée au manchon isolant tubulaire (20) de manière amovible.

7. Dispositif de détection de tension selon l'une quelconque des revendications précédentes, dans lequel le manchon isolant tubulaire (20) comprend une couche de commande de contrainte électrique (180, 200).

8. Dispositif de détection de tension selon la revendication 7, dans lequel la partie d'accouplement de prise (100) comprend une couche conductrice ou semiconductrice (220) sur une surface externe de la partie d'accouplement de prise (100), et dans lequel la couche de commande de contrainte électrique (180, 200) est électriquement connectée à la couche conductrice ou semiconductrice (220) sur la surface externe de la partie d'accouplement de prise.

9. Dispositif de détection de tension selon l'une quelconque des revendications précédentes, dans lequel la partie d'accouplement de prise (100) comprend, sur une surface interne de la partie d'accouplement de prise (100), une couche d'électrode haute tension conductrice (230) en contact électrique avec la tige (30) et formant une cage de Faraday autour d'une zone dans laquelle la fiche d'isolation à capteur (10) vient en contact avec la tige conductrice (30).

10. Dispositif de détection de tension selon l'une quelconque des revendications précédentes, dans lequel le manchon isolant tubulaire (20) est radialement expansible.

11. Dispositif de détection de tension selon l'une quelconque des revendications précédentes, dans lequel le manchon isolant tubulaire (20) comprend un ou plusieurs matériaux de caoutchouc polymère.

12. Dispositif de détection de tension selon l'une quelconque des revendications précédentes, dans lequel la longueur du manchon isolant tubulaire (20) est de trente centimètres ou plus.

13. Dispositif de détection de tension selon l'une quelconque des revendications précédentes, dans lequel la tige conductrice (30) comprend en outre une partie centrale (125) reliant la première partie d'extrémité (120) et la seconde partie d'extrémité (130), et dans lequel la partie centrale est disposée dans, et enveloppée par, le manchon isolant (20).

14. Appareillage de commutation à moyenne ou haute tension ou transformateur à moyenne ou haute tension pour un réseau de distribution d'énergie d'un réseau national comprenant un conducteur d'énergie, tel qu'une barre omnibus, sur tension élevée lorsqu'il est utilisé, et un dispositif de détection de tension selon l'une quelconque des revendications 1 à 13, dans lequel la première partie d'extrémité (120) de la tige conductrice (30) est électriquement connectée au conducteur d'énergie.

15. Réseau de distribution d'énergie dans un réseau national comprenant un conducteur d'énergie et un dispositif de détection de tension selon l'une quelconque des revendications 1 à 13, dans lequel la première partie d'extrémité (120) de la tige conductrice (30) est électriquement connectée au conducteur d'énergie.
